Europäisches Patentamt

European Patent Office

Office européen des brevets

(11) Publication number: **0 181 501**
**A2**

# (12) EUROPEAN PATENT APPLICATION

(21) Application number: **85112864.5**

(22) Date of filing: **10.10.85**

(51) Int. Cl.⁴: **H 01 L 21/82**

(30) Priority: **18.10.84 JP 220030/84**

(43) Date of publication of application:
**21.05.86 Bulletin 86/21**

(84) Designated Contracting States:
**DE FR GB**

(71) Applicant: **Matsushita Electronics Corporation**
**1006, Oaza-Kadoma Kadoma-shi**
**Osaka 571(JP)**

(72) Inventor: **Umemoto, Toshiaki**
**14-5, Koutari 3-chome**
**Nagaokakyo City 617(JP)**

(74) Representative: **Dr. Elisabeth Jung Dr. Jürgen**
**Schirdewahn Dipl.-Ing. Claus Gernhardt**
**P.O. Box 40 14 68 Clemensstrasse 30**
**D-8000 München 40(DE)**

(54) **Method for making complementary MOS integrated circuit.**

(57) Method for forming double well region to make complementary MOS integrated circuit comprising:
a first ion implantation for selectively injecting impurity of first conductivity type into semiconductor substrate (1) by using a photoresist pattern (8) for mask, a step for forming a thin film (9) on said photoresist pattern (8) and said semiconductor substrate (1) on which said photoresist pattern (8) is not formed, step of removing said photoresist pattern (8) on which said thin film is formed, and ion-implantation second step for selectively injecting impurity of second conductivity type in semiconductor substrate (1) by using said thin film (9) retained after said removing of said mask.

F I G 2 (b)

TITLE OF THE INVENTION

Method for making complementary MOS integrated circuit

FIELD OF THE INVENTION AND RELATED ART STATEMENT

1.  FIELD OF THE INVENTION

The present invention relates generally to improvements in method for making complementary MOS integrated circuit and more particularly to method for making complementary MOS integrated circuit which method is capable of preventing an oxidation-induced defect.

2.  DESCRIPTION OF THE RELATED ART

In recent years, double well complementary MOS integrated circuit is attracting attention in place of the conventional single well complementary MOS integrated circuit, because the former can individually optimize characters of N-MOS and P-MOS for well balance between the characters of N-MOS and P-MOS, while the single well complementary MOS integrated circuit has been difficult to apply to minute patterned integrated circuit because the single well complementary MOS integrated circuit cannot individually optimize characters of N-MOS and P-MOS for well balance between the characters of N-MOS and P-MOS.

N well regions and P well regions of the double well complementary MOS integrated circuit are usually produced by self-alignment method having only one time of photo masking step for attaining a high

1

degree of an integration and making the producing step simple.

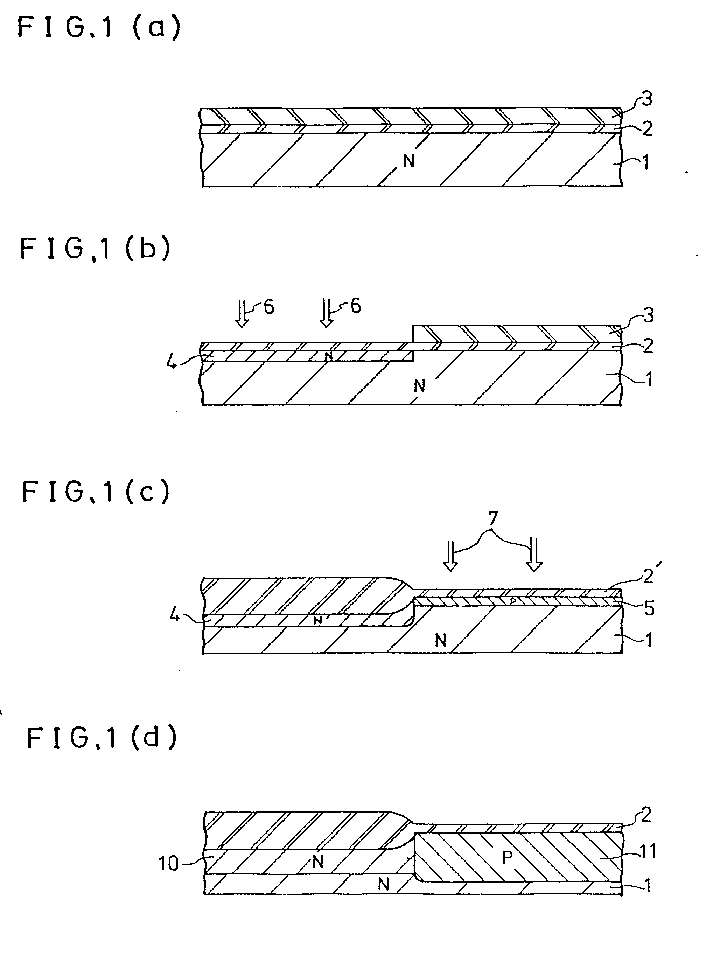

FIG.1a, FIG.1b, FIG.1c and FIG.1d show prior art self-alignment method for making N well and P well regions. As shown in FIG. 1a, a silicon nitride film 3 is formed on a thermal oxidation film 2 formed on a silicon substrate 1. As shown in FIG. 1b, a silicon nitride film 3 is selectively removed by photoetching method. An N-type region 4 is formed in the silicon substrate 1 by injecting accelerated ions 6 of N-type impurity. Next, a silicon dioxide thick film 2' is formed on the N-type region 4 by local oxidation using the silicon nitride film 3 as mask. As shown in FIG. 1c, a P-type region 5 is formed in the silicon substrate 1 by injecting accelerated ions 7 of P-type impurity using the silicon dioxide thick film 2' as mask. Next, as shown in FIG. 1d, an N well region and a P well region are formed by carrying out a drive-in to P-type region 5.

As mentioned above, the prior art method necessitates thermal oxidations for two time, a growth step for silicon dioxide film and an etching step for silicon dioxide film. Thus, the prior art method has disadvantage of complexity of steps and such a disadvantage that an oxidation-induced defect often occurs in the local oxidation.

OBJECT AND SUMMARY OF THE INVENTION

It is an object of the invention to provide an improved method for making double well complementary MOS integrated circuit, wherein the method is simple and does not lead to the oxidation-induced defect.

An improved method for making double well complementary MOS integrated circuit in accordance with the present invention comprises:

a first ion implantation for selectively injecting impurity of first conductivity type into semiconductor substrate by using a photoresist pattern for mask,

a step for forming a thin film on the photoresist pattern and the semiconductor substrate on which the photoresist pattern is not formed,

step of removing the photoresist pattern on which the thin film is formed, and

ion-implantation second step for selectively injecting impurity of second conductivity type in semiconductor substrate by using the thin film retained after the removing of the mask.

BRIEF DESCRIPTION OF THE DRAWING

FIG.1a, FIG.1b, FIG.1c and FIG.1d are cross-sectional side views for showing steps of a prior art method for making double well complementary MOS integrated circuit.

FIG.2a, FIG.2b, FIG.2c and FIG.2d are cross-sectional side views for showing steps of an embodiment of method for making double well complementary MOS
integrated circuit in accordance with the present
invention.

DETAILED DESCRIPTION OF THE PREFERRED EMBODIMENTS

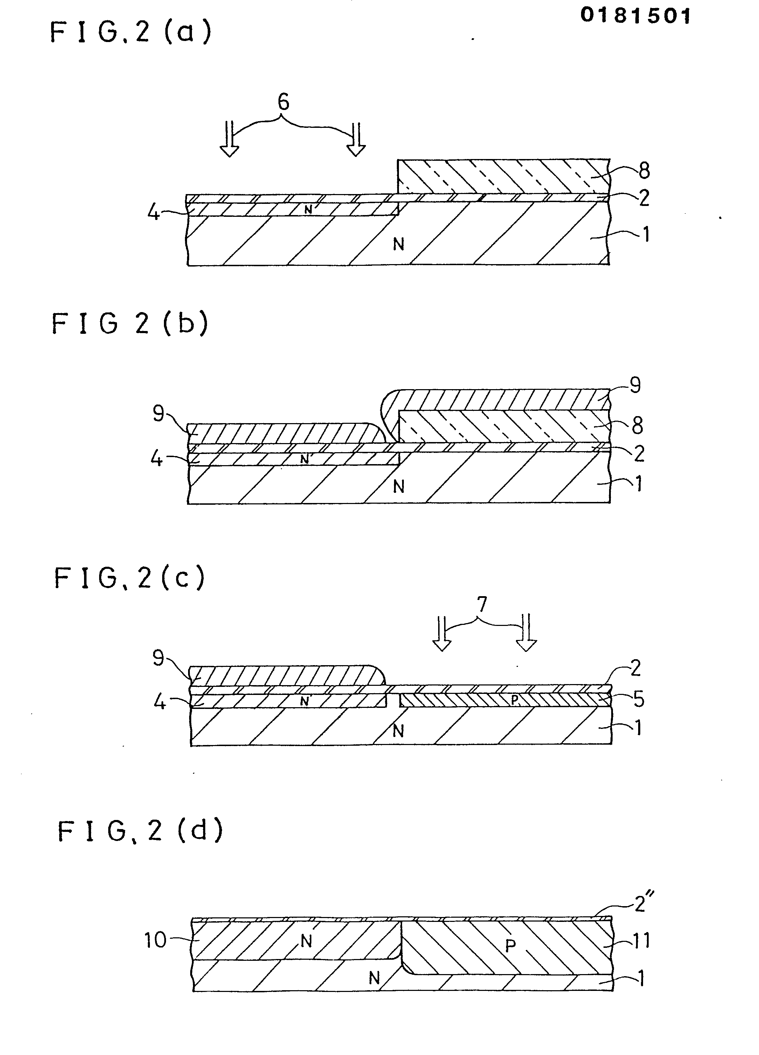

FIGs. 2a to 2d show steps of an embodiment of
method for making double well complementary MOS
integrated circuit. By thermal oxidation, an $SiO_2$ film
2 having about 50 nm thickness is formed on a surface
of an N-type silicon substrate 1 having specific
resistance of 20 to 50    cm. As shown in FIG. 2a, by
photolithographic method a photoresist pattern 8 which
has windows to form an ion implanted layer 4 is formed.
Next, the ion implanted layer 4 is formed in the
silicon substrate 1 by injecting accelerated ions 6 of
N-type impurity such as phosphoric ions. The
phosphoric ions are accelerated by acceleration
electrode having 100 KV and are injected with dose
amount of about $5x10^{12}/cm^2$.

The amount of the injection is desirable
within a range between $1x10^{12}/cm^2$ to $1x10^{13}/cm^2$. Next,
as shown in FIG. 2b, an aluminum thin film 9 having
about 0.4 m to 4 m (1 m is desirable) thickness is
evaporated, and subsequently the photoresist 8 is
removed. Therefore, the aluminum thin film 9 formed on
the photoresist 8 is lifted off and the aluminum thin
film 9 is retained only on the ion implanted layer 4.
Next, as shown in FIG. 2c, P-type ion implanted layer 5 is formed in the silicon substrate 1 by injecting accelerated ions 7 of P-type impurity such as boron ions. The boron ions are accelerated by an acceleration electrode impressed with 50 KV and are injected with dose amount of about $7\times10^{12}/cm^2$. Preferable amount of the injection is within a range between $1\times10^{12}/cm^2$ to $1\times10^{13}/cm^2$. Next, remaining aluminum thin film 9 is removed by known etching process using a phosphoric etching solution. After removing a surface layer of the $SiO_2$ film 2 for carrying out a washing, as shown in FIG. 2d, N well region 10 and P well region 11 are formed by carrying out a drive-in. A silicon dioxide film 2" is formed by the drive-in. Such process causes concentration of phosphor in the N well region 10 to about $5\times10^{16}/cm^3$ and that in the P well region 11 to about $7\times10^{16}/cm^3$. Experiments shows that both of impurity atom concentrations of the N well region 10 and the P well region 11 are desirable within a range between $1\times10^{16}/cm^3$ to $1\times10^{17}/cm^3$. Subsequent steps are the same as the prior art method for making complementary MOS integrated circuit.

As mentioned above, in accordance with the present invention a double well complementary MOS integrated circuit without the oxidation induced detect can be provided by simple steps.

CLAIMS

1.      Method for making complementary MOS integrated circuit comprising:

a first ion implantation for selectively injecting impurity of first conductivity type into semiconductor substrate (1) by using a photoresist pattern (8) for mask.

a step for forming a thin film (9) on said photoresist pattern (8) and said semiconductor substrate (1) on which said photoresist pattern (8) is not formed,

step of removing said photoresist pattern (8) on which said thin film (9) is formed, and

ion-implantation second step for selectively injecting impurity of second conductivity type in semiconductor substrate (1) by using said thin film (9) retained after said removing of said mask.

2.      Method for making complementary MOS integrated circuit in accordance with claim 1, wherein said semiconductor substrate (1) is made from N-type silicon.

3.      Method for making complementary MOS integrated circuit in accordance with claim 1, wherein said thin film (9) is made from aluminum.

4.      Method for making complementary MOS integrated circuit in accordance with claim 1, wherein a dose amount in said ion implantation first step is within a range from $1 \times 10^{12}/cm^2$ to $1 \times 10^{13}/cm^2$.

0 1 8 1 5 0 1

5.      Method for making complementary MOS integrated circuit in accordance with claim 1, wherein

a dose amount in said ion implantation second step is within a range from $1 \times 10^{12}/cm^2$ to $1 \times 10^{13}/cm^2$.

6.      Method for making complementary MOS integrated circuit comprises:

a first ion implantation for selectively injecting impurity of first conductivity type in semiconductor substrate by using a photoresist pattern (8) for mask,

forming a thin film (9) on said photoresist pattern (8) and said semiconductor substrate (1) on which said photoresist pattern (8) is not formed,

removing said photoresist pattern (8) on which said thin film (9) is formed,

second ion implantation for selectively injecting impurity of second conductivity type in semiconductor substrate (1) by using said thin film (9) retained after said removing step for mask, and

drive-in for forming a  N well region (10) and a P well region (11) by diffusing impurities of first and second conductivity type at same time.

7.      Method for making complementary MOS integrated circuit in accordance with claim 6, wherein

a concentration of impurity of surface of a N well region (10) is within a range from $1 \times 10^{16}/cm^3$ to $1 \times 10^{17}/cm^3$.

8.    Method for making complementary MOS integrated circuit in accordance with claim 6, wherein a concentration of impurity of surface of a P well region (ll) is within a range from $1 \times 10^{16}/cm^2$ to $1 \times 10^{17}/cm^2$.

FIG.1 (a)

FIG.1 (b)

FIG.1 (c)

FIG.1 (d)

0181501

# FIG.2 (a)

# FIG 2 (b)

# FIG.2 (c)

# FIG.2 (d)